# EUROPEAN PATENT APPLICATION

(11) **EP 1 187 260 A1**
(43) Date of publication of application: **13.03.2002**
(21) Application number: 01120091.2
(22) Date of filing: 21.08.2001
(51) Int. Cl.: H01R 12/34

(54) **Terminal for electrical and mechanical connection to a printed circuit board**

(30) Priority: 06.09.2000 US 655927
(71) Applicant: SIEMENS AKTIENGESELLSCHAFT, 80333 München (DE)
(72) Inventor: Ineson, David J., Oakville, CT 06779 (US); Van Zuilen, David, Fremont, IN 46737 (US)

(57) **Abstract**

The present invention relates to a terminal for creating a quick, simple and inexpensive mechanical and electrical connection to a PCB that can be easily removed and replaced. This terminal can be fixedly connected, mechanically and electrically, to a PCB by the forces created by the compressive force of the opening in the PCB and the resilient nature of the terminal. The terminal generally comprises a first and a second end. The first end may include two legs which are inserted into an opening in the PCB. The second end may include at least one projection for engaging a housing or other similar structure.

## Description

### BACKGROUND OF THE INVENTION

### Field of the Invention:

This invention relates to terminals that are connectable to and removable from printed circuit boards ("PCB(s)").

### Description of the Related Art:

Prior art terminals for connection to a PCB have typically required soldering to fixedly connect them to the PCB. Generally, a female terminal is soldered to the PCB and a male terminal is inserted into the female terminal. Alternately, the male terminal could be soldered directly to the PCB. Soldering and other similar methods of fixedly connecting the terminal to the PCB have many disadvantages including, requiring the extra step of soldering, potential shorting of the terminals and/or transmission lines on the PCB due to excess solder, and the inability to easily remove the terminal from the PCB.

U.S. Patent number 4,676,579 entitled "Compliant Terminal" (the "'579 patent) discloses a terminal that seeks to overcome some of the disadvantages associated with soldering and other similar methods of fixedly connecting terminals to PCBs. The terminal disclosed in the '579 patent includes a pair of legs that each have a free end and an inwardly facing projection. The inwardly facing projections of each leg face each other. The legs of the terminal are inserted into an opening in the PCB so that the free ends of the legs protrude from the opening into the opposite side of the PCB. As the legs of the terminal are inserted into an opening in a PCB, the inwardly facing projections are forced to meet. The point at which the inwardly facing projections meet acts as a fulcrum about which the free ends of the legs of the terminal swing outwardly and engage the opposite side of the PCB to prevent the terminal from slipping away from the opening. However, this terminal has an intricate shape that requires delicate and exact manufacture. Additionally, it is very difficult to remove the terminal once it is inserted, making it unsuitable for applications that require a removable and/or replaceable terminal.

### SUMMARY OF THE INVENTION

The present invention relates to a terminal for creating a quick, simple and inexpensive mechanical and electrical connection to a PCB that can be easily removed and replaced. This terminal can be fixedly connected, mechanically and electrically, to a PCB by the forces created by the compressive force of the opening in the PCB and the resilient nature of the terminal.

### BRIEF DESCRIPTION OF THE DRAWINGS

Fig. 1 is an isometric view of a preferred embodiment of a terminal.
Fig. 2 is a top plan view of a preferred embodiment of a terminal connected to a PCB.
Fig. 3 is a side plan view of a preferred embodiment of a terminal engaged with a housing.

### DETAILED DESCRIPTION OF THE PREFERRED EMBODIMENT

The figures and the following description are that of a single embodiment and are for the purpose of illustration and example and not for the purpose of limitation. It will be obvious to one skilled in the art that other configurations are possible.

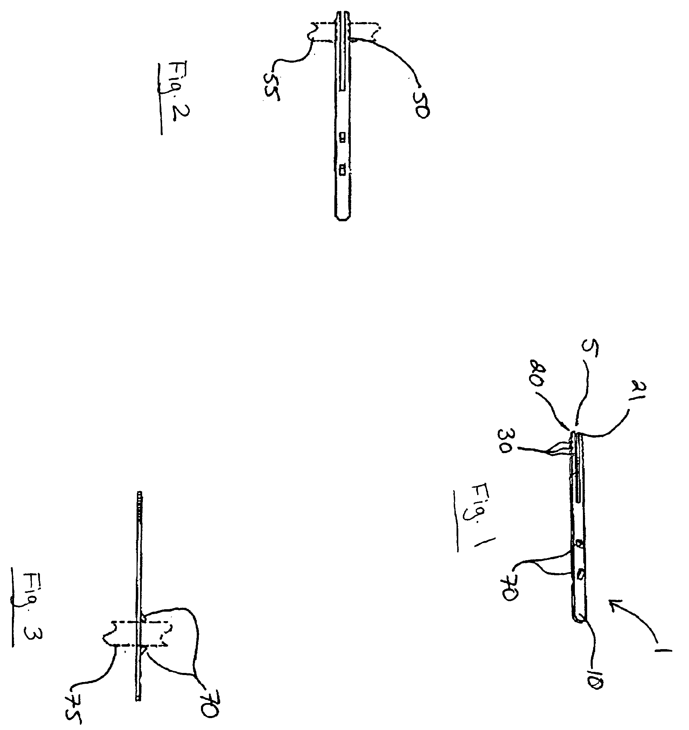

Fig. 1 shows an isometric view of an embodiment of the terminal 1. The terminal is generally made from a conductive material that is generally resilient but capable of being deformed. Examples of suitable materials include, but are not limited to, copper alloy and phosphorus bronze. The terminal 1 comprises a first end 5 and a second end 10. The first end generally comprises two legs 20 and 21 which each may contain a plurality of notches 30. Additionally, the end of each leg 20 and 21 is tapered along the leg's outer edge. The second end 10 includes at least one protrusion 70.

Fig. 2 shows an embodiment of the terminal 1 fixedly connected to a PCB 55. PCBs generally include a plurality of openings to facilitate the connection of a variety of components. The width of the first end of the terminal 1 is slightly larger than the opening in the PCB 55. The terminal is connected to the PCB by inserting the end of each leg 20 and 21 into an opening in the PCB 55. As the legs 20 and 21 are inserted, they are compressed toward each other by the PCB 55. Once the terminal 1 is inserted, the resilient nature of terminal 1 creates a force opposite to the compressive force created by the PCB 55 which fixedly connects terminal 1 to the PCB 55. The terminal 1 is removable from the PCB 55 by pulling the terminal in a direction perpendicular to the plane of the PCB 55. Notches 30 may also be included along the outer edge of each of the legs to enhance the connection.

Fig. 3 shows an embodiment of the terminal 1 engaged with a housing 75. In the illustrated embodiment, the second end 10 of the terminal 1 contains two protrusions 70 on the same side of the terminal 1. These protrusions slant inwardly towards each other. This configuration of the protrusions 70 allow the terminal 1 to be engaged with a housing 75 or other structure in such a way as to prevent motion in the plane of the terminal 1 between the terminal and the housing 75. It would be obvious to one skilled in the art that other configurations and number of protrusions are possible to engage the terminal 1 with a variety of structures.

## Claims

1. A terminal for electrical and mechanical connection to a printed circuit board, wherein the terminal is fixedly connected by compression to and removable from the printed circuit board, comprising:
a first end, wherein the first end is compressed when inserted into the printed circuit board; and
a second end, enagagable to a housing.

2. A terminal as claimed in Claim 1, wherein the first end comprises two legs.

3. A terminal as claimed in Claim 2, wherein the two legs each include a plurality of notches.

4. A terminal as claimed in Claim 1, wherein the second end includes at least one protrusion for engaging a housing.

5. A terminal for electrical and mechanical connection to a printed circuit board, wherein the terminal is fixedly connected by compression to and removable from the printed circuit board, comprising:
a first end comprising two legs, wherein each leg includes a plurality of notches and wherein the first end is compressed when inserted into the printed circuit board; and
a second end, wherein the second end includes at least one protrusion for engaging a housing.

6. A terminal as claimed in Claim 5, wherein the terminal is comprised of copper alloy.

7. A terminal as claimed in Claim 5, wherein the terminal is comprised of phosphorus bronze.
